# FASCICULE DE BREVET EUROPEEN

(11) **EP 3 650 925 B1**
(45) Date de publication et mention de la délivrance du brevet: **22.12.2021**
(21) Numéro de dépôt: 19208131.3
(22) Date de dépôt: 08.11.2019
(51) Int. Cl.: G02F 1/01, G02F 1/025, G02F 1/225, G02F 1/313, G02F 1/21

(54) **COMMUTATEUR OPTOELECTRONIQUE A INTERFEROMETRE DE MACH-ZEHNDER**
OPTISCHER SCHALTER MIT MACH-ZEHNDER INTERFEROMETER
MACH-ZEHNDER INTERFEROMETER OPTICAL SWITCH

(30) Priorité: 12.11.2018 FR 1860415
(43) Date de publication de la demande: 13.05.2020
(73) Titulaire: Commissariat à l'énergie atomique et aux énergies alternatives (CEA), 75015 Paris (FR)
(72) Inventeur: CHARBONNIER, Benoit, 38054 Grenoble cedex 09 (FR); FOWLER, Daivid, 38054 Grenoble cedex 09 (FR)
(74) Mandataire: INNOV-GROUP

(56) Documents cités:
- EP-A1- 3 740 817
- US-A1- 2007 292 075
- US-A1- 2008 094 123
- US-A1- 2016 013 868
- US-A1- 2017 099 529

## Description

### DOMAINE TECHNIQUE

Le domaine de l'invention est celui des commutateurs optoélectroniques de type Mach-Zehnder pouvant être utilisés dans les circuits intégrés photoniques, notamment dans le cadre de la photonique sur silicium.

### ÉTAT DE LA TECHNIQUE ANTÉRIEURE

Les circuits intégrés photoniques (PIC pour *Photonic Integrated Circuit,* en anglais) sont formés de composants photoniques actifs (commutateurs, modulateurs, diodes...) et passifs (guides d'onde, multiplexeurs...) couplés optiquement les uns aux autres. Les commutateurs optoélectroniques sont utilisés notamment dans le cadre du routage de signaux optiques. Ils peuvent être du type à interféromètre de Mach-Zehnder ou du type à anneau résonant. Les interféromètres de Mach-Zehnder, bien que présentant une surface plus importante au sein du circuit PIC que celle des interféromètres à anneau résonant, ont l'avantage de présenter une large bande spectrale de fonctionnement (*broadband,* en anglais).

L'interféromètre de Mach-Zehnder du commutateur optoélectronique est habituellement un interféromètre 2×2 comportant un coupleur d'entrée à deux ports d'entrée destinés à recevoir un signal optique entrant, un coupleur de sortie ayant deux ports de sortie destinés à fournir le signal optique sortant, les deux coupleurs étant reliés entre eux par deux guides d'onde distincts appelés bras dans lesquels circulent des signaux optiques issus du même signal optique entrant.

Dans le but de commuter le signal optique sortant de l'un à l'autre des deux ports de sortie, un déphaseur optique est disposé sur au moins l'un des bras, qui permet de générer une variation de la phase du signal optique circulant dans le bras considéré, et ainsi de générer une différence de phase entre les signaux optiques reçus par le coupleur de sortie. En fonction des interférences constructives ou destructives entre les signaux optiques circulant dans les bras, le signal optique sortant sera fourni par l'un ou l'autre des ports du coupleur de sortie.

Le déphaseur optique est classiquement à effet électro-réfractif ou à effet thermo-optique. Dans les deux cas, la variation de la phase est obtenue par une variation de l'indice de réfraction du matériau formant le cœur du guide d'onde considéré. Cette modification de l'indice de réfraction peut être obtenue par modification de la densité en porteurs libres dans le cas du déphaseur électro-réfractif, ou par modification de la température appliquée au bras dans le cas du déphaseur thermo-optique.

D'une manière générale, un tel commutateur optoélectronique de type Mach-Zehnder doit posséder de bonnes performances, notamment en termes de temps de commutation, de pertes d'insertion, et d'isolation optique entre les ports du coupleur de sortie.

Le temps de commutation est la durée nécessaire au basculement de la majorité de l'intensité optique de l'un à l'autre des ports de sortie. Elle peut être de l'ordre de quelques nanosecondes dans le cas d'un déphaseur électro-réfractif ou de l'ordre de quelques microsecondes dans le cas d'un déphaseur thermo-optique.

Les pertes d'insertion (IL, pour *Insertion Losses,* en anglais) représentent ici les pertes optiques associées au commutateur, et dépendent du rapport Iᵢₙ/Iₒᵤₜ entre l'intensité optique Iᵢₙ du signal optique entrant sur l'intensité optique Iₒᵤₜ du signal optique sortant en l'absence de diaphotie (c'est-à-dire lorsque l'intensité optique est maximale sur le port passant du coupleur de sortie et minimale sur le port non-passant).

L'isolation optique entre les ports du coupleur de sortie est évaluée par le taux d'extinction (ER, pour *Extinction Ratio,* en anglais) qui dépend du rapport I_{out,on/}I_{out,off} entre l'intensité optique maximale I_{out,on} obtenue sur un port du coupleur de sortie en mode passant, et l'intensité optique minimale I_{out,off} obtenue sur ce même port en mode bloquant. Une mauvaise isolation optique entre les ports, qui se traduit par la présence d'un signal optique non voulu au niveau du port non-passant du coupleur de sortie, est représentative du phénomène de diaphotie (*optical crosstalk,* en anglais) qui provient notamment d'un déséquilibre entre les pertes optiques au niveau des bras.

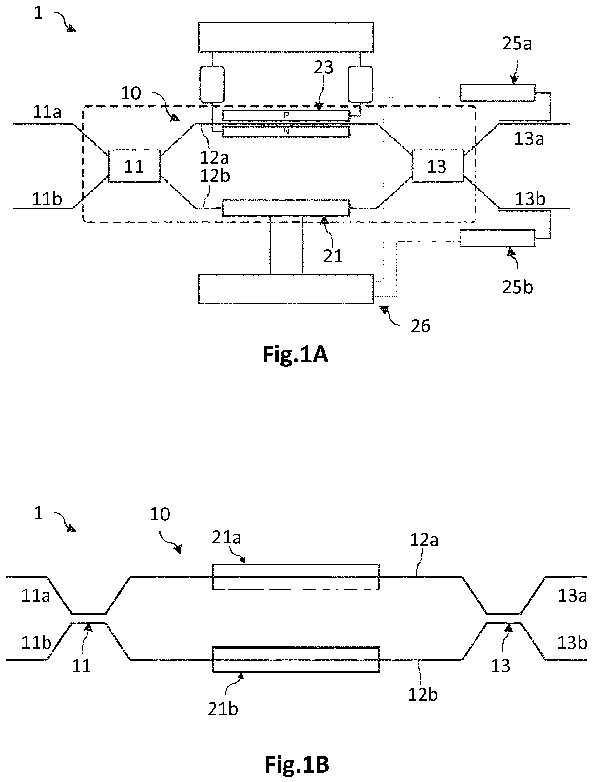

La demande de brevet US2017/0293200 décrit un commutateur de type Mach-Zehnder utilisant un déphaseur électro-réfractif pour assurer la commutation du signal optique de l'un à l'autre des ports de sortie, et présentant un faible temps de commutation ainsi qu'une diaphotie réduite. Pour cela, comme l'illustre la figure 1A, le commutateur 1 comporte un interféromètre 10 de Mach-Zehnder muni d'un déphaseur électro-réfractif 23 dont l'activation permet de commuter le signal optique sortant sur l'un ou l'autre des ports 13a, 13b du coupleur de sortie 13. Dans le but de corriger un déséquilibre des phases optiques entre les bras 12a, 12b et ainsi d'augmenter le taux d'extinction ER, le commutateur 1 comporte un module de correction dynamique 26, formé d'un déphaseur thermo-optique 21 disposé dans le second bras 12b et de deux photodétecteurs 25a, 25b couplés optiquement aux ports 13a, 13b du coupleur de sortie 13. Ainsi, à partir des signaux de mesure transmis par les photodétecteurs 25a, 25b, le déphaseur thermo-optique 21 est plus ou moins activé de manière à compenser les erreurs de phase entre les signaux optiques circulant dans les bras 12a, 12b, ce qui permet d'augmenter le taux d'extinction ER (et donc de diminuer la diaphotie). Cependant, il apparaît que le déphaseur électro-réfractif, bien que permettant d'obtenir une commutation rapide, induit des pertes d'insertion non négligeables ainsi qu'une diaphotie qu'il convient de corriger. Le document US2017/099529 décrit un exemple d'un commutateur de type Mach-Zehnder similaire à celui de la demande de brevet US2017/0293200. Ici également, la commutation est assurée par des déphaseurs électro-optiques, et des déphaseurs thermo-optiques sont prévus pour minimiser les erreurs de phase.

Le document Matsuura et al. intitulé Accelerating Switching Speed of thermo-optic MZI Silicon-Photonic Switches with 'Turbo Pulse' in PWM Control, Optical Fiber Communications Conférence and Exhibition (OFC), 2017, illustre une autre approche qui consiste à utiliser des déphaseurs thermo-optiques pour assurer la commutation du signal optique de l'un à l'autre des ports de sortie. Il décrit un commutateur optoélectronique de type Mach-Zehnder à faible diaphotie et faibles pertes d'insertion, dont le temps de commutation est diminué. Comme l'illustre la figure 1B, l'interféromètre 10 de Mach-Zehnder comporte deux déphaseurs thermo-optiques 21a, 21b disposés dans les bras 12a, 12b. La commutation est assurée par l'activation de l'un ou l'autre des déphaseurs thermo-optiques 21a, 21b. Ces derniers ne présentent sensiblement pas de pertes d'insertion, de sorte que des pertes optiques entre les bras 12a, 12b sont sensiblement équilibrées, conduisant à une bonne isolation entre les ports du coupleur de sortie. Les auteurs montrent que le temps de commutation peut être diminué en appliquant à l'un ou l'autre des déphaseurs thermo-optiques 21a, 21b un signal de commutation présentant un pic de puissance électrique suivi d'un retour à une valeur nominale constante. Il apparaît que la variation de la température générée par le déphaseur thermo-optique 21a, 21b jusqu'à la température nominale de commutation est plus rapide, permettant alors de diminuer le temps de commutation d'une vingtaine de microsecondes à quelques microsecondes. Cependant, il apparaît que le temps de commutation reste ici de l'ordre de grandeur d'une commutation de type thermo-optique, c'est-à-dire de l'ordre de quelques microsecondes. De plus, la commande des déphaseurs thermo-optiques est relativement contraignante dans la mesure où elle implique l'utilisation de pic de puissance électrique.

Le document US2016/013868A1 porte sur un démultiplexeur à interféromètre de Mach-Zehnder ; les documents US2008/094123A1 et US2007/292075A1 portent sur des modulateurs à interféromètre de Mach-Zehnder.

Le document EP3740817A1 décrit un commutateur à interféromètre de Mach-Zehnder, comportant un dispositif de commutation ayant deux déphaseurs thermo-optiques et deux déphaseurs électro-réfractifs.

### EXPOSÉ DE L'INVENTION

L'invention a pour objectif de remédier au moins en partie aux inconvénients de l'art antérieur, et plus particulièrement de proposer un commutateur optoélectronique à faibles pertes d'insertion et taux d'extinction élevé, et présentant un faible temps de commutation.

Pour cela, l'objet de l'invention est un commutateur optoélectronique, comportant :
∘ un interféromètre de Mach-Zehnder, comportant :
   - un coupleur d'entrée, comportant au moins un premier port d'entrée adapté à recevoir un signal optique dit entrant ;
   - un premier et un deuxième guides d'onde dits bras, reliés au coupleur d'entrée, adaptés à transmettre des signaux optiques, issus du signal optique entrant, et pouvant présenter une différence de phase dite effective ;
   - un coupleur de sortie, relié aux bras, et comportant deux ports de sortie, pour fournir un signal optique dit sortant,
∘ un dispositif de commutation, comportant :
   - au moins deux déphaseurs thermo-optiques disposés au niveau des bras,
   - un module de commutation adapté à appliquer aux déphaseurs thermo-optiques un signal continu, dit de commutation, d'intensité constante durant toute la durée séparant deux instructions de commutation consécutives, de manière à générer une composante dite thermo-optique de la différence de phase effective, qui varie jusqu'à une valeur finale prédéterminée se traduisant par une commutation du signal optique sortant sur l'un ou l'autre des ports de sortie.

De plus, le dispositif de commutation comporte en outre :
- au moins deux déphaseurs électro-réfractifs disposés au niveau des bras,
- un module de compensation adapté à appliquer aux déphaseurs électro-réfractifs un signal transitoire, dit de compensation, d'intensité variable durant toute la durée séparant deux instructions de commutation consécutives, de manière à générer une composante supplémentaire, dite électro-réfractive, de la différence de phase effective, ladite intensité variable étant déterminée de manière à minimiser un écart entre la valeur finale prédéterminée et la différence de phase effective.

Selon l'invention, le dispositif de commutation comporte en outre au moins un photodétecteur couplé à l'un des ports de sortie et connecté au module de compensation, le module de compensation comportant un calculateur pour déterminer, sur la base de signaux de mesure transmis par le photodétecteur, l'intensité variable à appliquer de manière à minimiser ledit écart entre la valeur finale prédéterminée et la différence de phase effective.

Certains aspects préférés mais non limitatifs de ce commutateur optoélectronique sont les suivants.

Les déphaseurs électro-réfractifs peuvent être des diodes pin, des diodes pn, ou des structures capacitives à accumulation de porteurs.

Les bras peuvent être réalisés à base de silicium.

L'interféromètre de Mach-Zehnder peut être un interféromètre 2×2 dont le coupleur d'entrée comporte deux ports d'entrée.

L'invention porte également sur un procédé de commutation d'un signal optique de sortie de l'un à l'autre des ports de sortie d'un commutateur optoélectronique selon l'une quelconque des caractéristiques précédentes, comportant les étapes suivantes :
i) application du signal de commutation aux déphaseurs thermo-optiques de manière à générer la composante thermo-optique de la différence de phase effective, qui varie jusqu'à la valeur finale prédéterminée se traduisant par la commutation du signal optique sortant ;
ii) application du signal transitoire de compensation aux déphaseurs électro-optiques de manière à générer la composante électro-réfractive de la différence de phase effective, dont l'intensité variable est déterminée de manière à minimiser ledit écart entre la valeur finale prédéterminée et la différence de phase effective.

Le signal de commutation peut être adapté à entraîner une variation allant de ο à π, et inversement, de la contribution thermo-optique de la différence de phase effective, sur une durée caractéristique de variation dite thermo-optique.

Le signal de compensation peut être adapté à entraîner :
- une variation allant de ο à ±π de la composante électro-réfractive de la différence de phase effective, sur une durée caractéristique de variation dite électro-réfractive inférieure à la durée caractéristique de variation thermo-optique,
- suivie d'un retour à ο, sur une durée caractéristique de variation sensiblement égale à la durée caractéristique de variation thermo-optique.

En l'absence de différence de phase entre les signaux optiques circulant dans les bras, le signal optique sortant peut être émis au deuxième port du coupleur de sortie, la commutation du deuxième port au premier port du coupleur de sortie peut comporter les étapes suivantes :
- une application du signal de commutation, de sorte que la composante thermo-optique de la différence de phase effective passe de ο à π ;
- une application du signal de compensation, de sorte que la composante électro-réfractive de la différence de phase effective passe de ο à π, puis diminue jusqu'à ο à mesure que la composante thermo-optique augmente progressivement de ο à π.

L'application du signal de commutation peut revenir à appliquer au déphaseur thermo-optique situé dans le premier bras un signal continu d'intensité constante V_{TO,π} entraînant une variation de π de la phase du signal optique circulant dans le premier bras, et à appliquer au déphaseur thermo-optique situé dans le deuxième bras un signal d'intensité nulle.

L'application du signal de compensation peut revenir à appliquer au déphaseur électro-réfractif situé dans le premier bras un signal transitoire d'intensité variable passant de ο à une valeur V_{ER,π} entraînant une variation de π de la phase du signal optique circulant dans le premier bras, suivie d'une diminution à une valeur nulle à mesure que la composante thermo-optique augmente progressivement de ο à π, et à appliquer au déphaseur électro-réfractif situé dans le deuxième bras un signal d'intensité nulle.

En l'absence de différence de phase entre les signaux optiques circulant dans les bras, le signal optique sortant étant émis au deuxième port du coupleur de sortie, la commutation du premier port au deuxième port du coupleur de sortie peut comporter :
- une application du signal de commutation, de sorte que la composante thermo-optique passe de π à ο ;
- une application du signal de compensation, de sorte que la composante électro-réfractive passe de ο à -π, puis augmente jusqu'à ο, à mesure que la composante thermo-optique diminue progressivement de π à o.

L'application du signal de commutation peut revenir à appliquer au déphaseur thermo-optique situé dans le premier bras un signal continu d'intensité constante V_{TO,π}, et à appliquer au déphaseur thermo-optique situé dans le deuxième bras un signal continu d'intensité constante V_{TO,π} entraînant une variation de π de la phase du signal optique circulant dans le deuxième bras.

L'application du signal de compensation peut revenir à appliquer au déphaseur électro-réfractif situé dans le premier bras un signal d'intensité nulle, et à appliquer au déphaseur électro-réfractif situé dans le deuxième bras un signal d'intensité variable passant de ο à une valeur V_{ER,π} entraînant une variation de π de la phase du signal optique circulant dans le deuxième bras, suivie d'un retour à une valeur nulle à mesure que la composante thermo-optique diminue progressivement de π à o.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A et 1B, déjà décrites, sont des vues schématiques et partielles de différents exemples de commutateurs optoélectroniques selon l'art antérieur ;
la figure 2 est une vue schématique et partielle d'un commutateur optoélectronique selon un mode de réalisation ;
la figure 3 illustre l'évolution temporelle :
   ▪ du signal de commutation V_{TOa}, V_{TOb} appliqué aux déphaseurs thermo-optiques, et de la contribution thermo-optique ΔΦ_{TO} qui en résulte ;
   ▪ du signal de compensation V_{ERa}, V_{ERb} appliqué aux déphaseurs électro-réfractifs, et de la contribution électro-réfractive Δφ_{ER} qui en résulte ; et
   ▪ de la différence de phase effective Δφ_{eff} correspondant à la somme de la composante thermo-optique Δφ_{TO} et de la composante électro-réfractive ΔΦ_{ER} ;

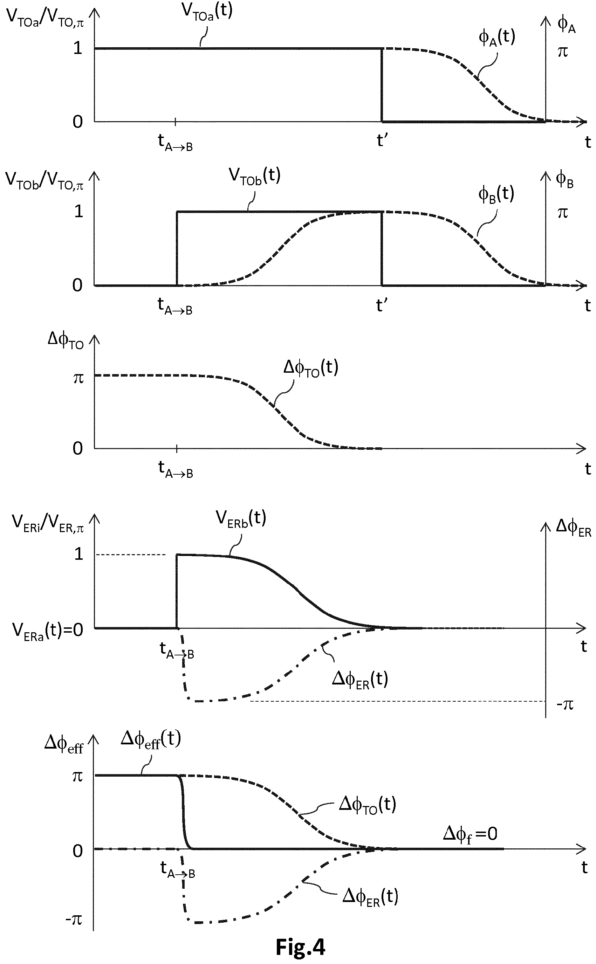

la figure 4 illustre l'évolution temporelle :
   ▪ du signal de commutation V_{TOa} appliqué au déphaseur thermo-optique du premier bras, et de la variation de phase φ_{A} qui en résulte ;
   ▪ du signal de commutation V_{TOb} appliqué au déphaseur thermo-optique du deuxième bras, et de la variation de phase φ_{B} qui en résulte ;
   ▪ de la composante thermo-optique Δφ_{TO} qui en résulte ;
   ▪ du signal de compensation V_{ERa}, V_{ERb} appliqué aux déphaseurs électro-réfractifs, et de la composante électro-réfractive ΔΦ_{ER} qui en résulte ; et
   ▪ de la différence de phase effective Δφ_{eff} correspondant à la somme de la composante thermo-optique ΔΦ_{TO} et de la composante électro-réfractive ΔΦ_{ER} ;

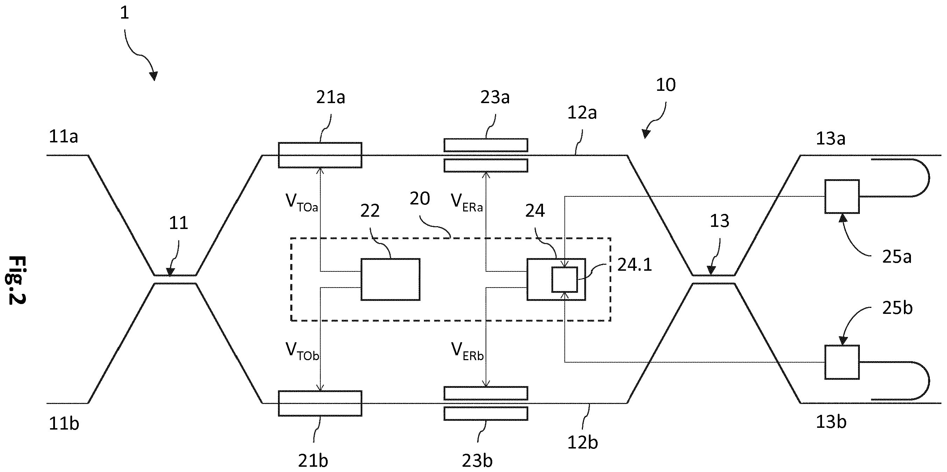

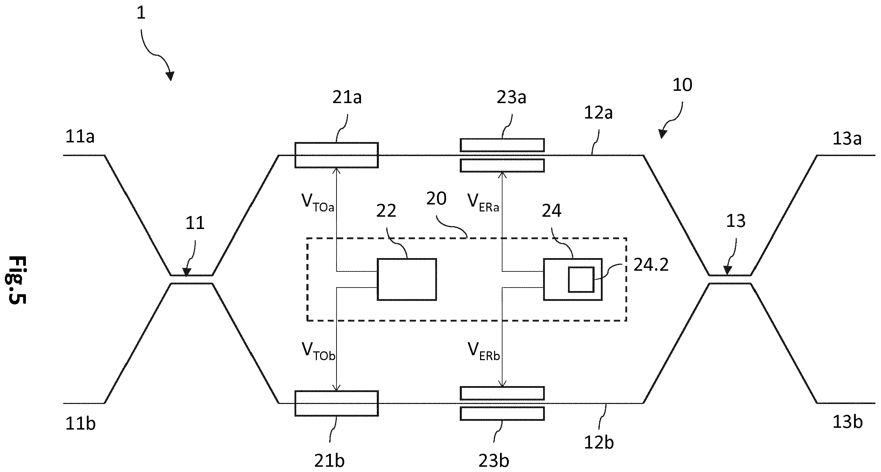

la figure 5 est une vue schématique et partielle d'un commutateur optoélectronique selon une variante du mode de réalisation illustré sur la fig.2.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près.

L'invention porte sur un commutateur optoélectronique de type Mach-Zehnder. Il comporte un interféromètre de Mach-Zehnder présentant au moins une entrée pour recevoir un signal optique dit entrant, et ici deux entrées (cas d'un interféromètre 2×2), et deux sorties distinctes pour fournir le signal optique dit sortant, et un dispositif de commutation adapté à commuter le signal optique sortant de l'un à l'autre des sorties.

Un tel commutateur optoélectronique est de préférence présent dans une puce optique permettant le routage de signaux optiques, la puce optique étant réalisée dans le cadre de la technologie dite photonique sur silicium. Les guides d'onde du commutateur optoélectronique peuvent ainsi être réalisés à base de silicium et intégrés dans un substrat de type SOI (*Silicon-On-Isulator*)*.* Le dispositif de commutation comporte au moins deux déphaseurs thermo-optiques et au moins deux déphaseurs électro-réfractifs, disposés à raison d'au moins un déphaseur thermo-optique et au moins un déphaseur électro-réfractif par bras.

La figure 2 est une vue schématique et partielle d'un commutateur optoélectronique 1 de type Mach-Zehnder (MZ) selon un mode de réalisation.

Le commutateur optoélectronique 1 comporte un interféromètre 10 de Mach-Zehnder et un dispositif de commutation 20 à base de déphaseurs thermo-optiques 21a, 21b et de déphaseurs électro-réfractifs 23a, 23b. Dans cet exemple, la commande des déphaseurs électro-réfractifs 23a, 23b est effectuée à partir de signaux de mesure transmis par des photodétecteurs 25a, 25b couplés optiquement aux deux ports 13a, 13b du coupleur de sortie 13.

L'interféromètre 10 de Mach-Zehnder comporte au moins un port d'entrée 11a d'un coupleur 11 destiné à recevoir un signal optique dit entrant d'intensité Iᵢₙ. Le coupleur d'entrée 11 est de préférence un coupleur d'interférence multimode (MMI pour *Multi Mode Interference*) comportant deux ports d'entrée 11a, 11b et divisant le signal optique entrant en deux signaux optiques de même intensité dans un premier et un deuxième guides d'onde 12a, 12b qui forment les bras de l'interféromètre 10. Le signal optique entrant est un signal optique continu et monochromatique, dont la longueur d'onde peut être égale, à titre d'exemple, à 1,31µm environ dans le cas d'applications dites datacom, ou égale à 1,55µm environ dans le cas d'applications de télécom.

Les deux bras 12a, 12b sont reliés optiquement à un coupleur de sortie 13 qui comporte deux ports de sortie 13a, 13b. Le coupleur de sortie 13 est de préférence un coupleur d'interférence multimode, et combine les deux signaux optiques incidents pour fournir un signal optique sortant sur l'un ou l'autre des ports de sortie 13a, 13b selon que les interférences entre les deux signaux optiques incidents sont constructives ou destructives. Aussi, dans le cas où l'interféromètre 10 est un interféromètre 2×2 comportant des coupleurs MMI, le premier bras 12a est directement relié au premier port d'entrée 11a et au premier port de sortie 13a, et le deuxième bras 12b est directement relié au deuxième port d'entrée 11b et au deuxième port de sortie 13b.

Ainsi, à titre d'exemple, si la différence de phase dite effective Δφ_{eff}=φ_{A}-φ_{B}, définie comme étant la différence entre la phase φ_{A} du signal optique circulant dans le premier bras 12a et la phase φ_{B} du signal optique circulant dans le deuxième bras 12b, est sensiblement nulle Δφ_{eff}=ο, le commutateur 1, recevant un signal optique entrant sur le port d'entrée 11a, fournit alors un signal optique d'intensité maximale sur le port de sortie 13b. Le deuxième port de sortie 13b est alors le port dit passant, et le premier port de sortie 13a est le port dit non-passant ou bloquant. De même, si la différence de phase effective Δφ_{eff} est sensiblement égale à π, le commutateur 1 fournit alors un signal optique sortant sur le premier port de sortie 13a, le deuxième port 13b étant alors le port non passant. La différence de phase effective Δφ_{eff}, comme décrit en détail plus loin, peut comporter une composante dite thermo-optique ΔΦ_{TO} générée par les déphaseurs thermo-optiques 21a, 21b, et une composante dite électro-réfractive ΔΦ_{ER} générée par les déphaseurs électro-réfractifs 23a, 23b. Elle est dite effective dans la mesure où elle correspond à la différence de phase instantanée, à l'instant t, entre les signaux optiques circulant dans les bras de l'interféromètre 10.

Le commutateur 1 comporte un dispositif de commutation 20 adapté à assurer la commutation du signal optique sortant sur l'un ou l'autre des ports de sortie, à réception d'une instruction de commutation émise par un contrôleur (non représenté) auquel il est connecté, et à maintenir le signal optique sortant sur le port de sortie 13a, 13b choisi durant toute la durée T nécessaire. La durée T est celle qui sépare deux instructions de commutation. Pour cela, il comporte au moins deux déphaseurs thermo-optiques 21a, 21b et un module de commutation 22.

Les déphaseurs thermo-optiques 21a, 21b, également appelés chaufferettes, sont disposés dans les bras 12a, 12b, à raison d'au moins un déphaseur thermo-optique par bras. Chaque déphaseur thermo-optique 21a, 21b est adapté à modifier la phase du signal optique circulant dans un bras considéré sous l'effet Joule induit par un courant électrique appliqué à celui-ci. Autrement dit, le déphaseur thermo-optique 21a, 21b applique une température au guide d'onde 12a, 12b qui entraîne une modification de la phase du signal optique. Pour cela, le déphaseur thermo-optique 21a, 21b peut être formé d'une bande réalisée en un matériau résistif, par exemple métallique, disposée le long d'une zone d'intérêt du guide d'onde 12a, et espacée de celui-ci pour ne pas induire de pertes optiques. Comme mentionné précédemment en référence à l'art antérieur, un déphaseur thermo-optique 21a, 21b présente un temps de commutation Δt_{TO} (durée caractéristique de variation) relativement long, habituellement de l'ordre de quelques microsecondes, mais ne présente sensiblement pas de pertes d'insertions ni de variation de pertes d'insertion, et n'entraîne donc sensiblement pas de dégradation du taux d'extinction (bonne isolation entre les deux ports de sortie).

Le module de commutation 22 est adapté à appliquer aux déphaseurs thermo-optiques 21a, 21b un signal continu, dit de commutation, d'intensité constante, de manière à générer une composante dite thermo-optique Δφ_{TO}(t) de la différence de phase effective Aφ_{eff}(t) entre les signaux optiques circulant dans les bras 12a, 12b. Cette composante thermo-optique Δφ_{TO}(t) varie d'une valeur initiale Δφᵢ jusqu'à une valeur finale prédéterminée Δφ_{f}, se traduisant par une commutation du signal optique sortant de l'un à l'autre des ports de sortie 13a, 13b.

Pour cela, le module de commutation 22 est connecté aux déphaseurs thermo-optiques 21a, 21b. A réception d'une instruction de commutation par le dispositif de commutation 20, le module 22 applique un signal de commutation V_{TOa}, V_{TOb} aux déphaseurs thermo-optiques 21a, 21b. Ce signal de commutation V_{TOa}, V_{TOb} est continu et d'intensité constante durant toute la durée T séparant deux instructions de commutation consécutives. L'intensité du signal de commutation V_{TOa}, V_{TOb} appliqué aux déphaseurs thermo-optiques 21a, 21b est égale, soit à V_{TO,ref}, soit à V_{TO,ref}+V_{TO,π}. La valeur V_{TO,ref} est une valeur de référence, constante dans le temps, pouvant être nulle. La valeur V_{TO,π} est également constante dans le temps et est sensiblement égale à l'intensité à appliquer pour que le déphaseur thermo-optique 21a, 21b génère une variation de π de la phase φ du signal optique circulant dans le bras considéré 12a, 12b.

Ainsi, comme détaillé plus loin, lorsque le signal optique est entrant par le premier port d'entrée 11a, et pour obtenir un signal optique sortant par le deuxième port de sortie 13b, le module de commutation 22 applique un même signal continu de commutation V_{TOa}, V_{TOb} d'intensité constante V_{TO,ref} à chacun des deux déphaseurs thermo-optiques 21a, 21b. Ces deux signaux étant de même intensité, la composante thermo-optique ΔΦ_{TO} de la différence de phase Δφ_{eff} est sensiblement nulle. Ensuite, à réception d'une instruction de commutation du deuxième port 13b au premier port de sortie 13a, le module de commutation 22 applique un signal continu de commutation V_{TOb} d'intensité constante V_{TO,ref} au deuxième déphaseur thermo-optique 21b et un signal continu de commutation V_{TOa} d'intensité constante égale à V_{TO,ref}+V_{TO,π} au premier déphaseur thermo-optique 21a. Ainsi, la composante thermo-optique Δφ_{TO} qui en résulte est sensiblement égale à π. Le signal optique sortant commute alors du deuxième port 13b au premier port de sortie 13a.

Notons que la composante thermo-optique Aφ_{TO} de la différence de phase effective Δφ_{eff}, varie entre ο et π, moyennant un déphasage Δϕₒ pouvant correspondre à un biais naturel que peut présenter l'interféromètre 10 de Mach-Zehnder. La prise en compte de ce déphasage Δϕₒ peut être faite lors de l'application du signal de commutation V_{TOa}, V_{TOb} aux déphaseurs thermo-optiques 21a, 21b. Dans le cas où ce déphasage Δϕₒ varie dans le temps, notamment du fait d'une dérive thermique de l'interféromètre 10, une correction dynamique peut être effectuée via des photodétecteurs couplés optiquement aux ports 13a, 13b du coupleur de sortie 13.

Selon l'invention, le dispositif de commutation 20 comporte des éléments supplémentaires permettant de réduire fortement le temps de commutation du commutateur 1. Pour cela, le dispositif de commutation 20 comporte au moins deux déphaseurs électro-réfractifs 23a, 23b disposés dans les bras 12a, 12b de l'interféromètre 10, et un module de compensation 24 adapté à appliquer aux déphaseurs électro-réfractifs 23a, 23b un signal transitoire, dit de compensation, d'intensité variable.

D'une manière générale, un déphaseur électro-réfractif 23a, 23b est adapté à modifier la phase du signal optique le traversant sous l'effet d'une modification de la densité de porteurs libres présents dans une zone dite active du guide d'onde 12a, 12b qui modifie en conséquence son indice de réfraction. Aussi, le guide d'onde 12a, 12b comporte, dans la zone active, une jonction semiconductrice s'étendant suivant l'axe longitudinal du guide d'onde 12a, 12b. La jonction semiconductrice est de type pin ou pn, voire est une jonction capacitive. La modification de la densité des porteurs libres dans la zone active du guide d'onde 12a, 12b, lors de la polarisation de la jonction semiconductrice, peut être effectuée par déplétion de porteurs ou par injection de porteurs, voire par accumulation de porteurs dans le cas d'une jonction capacitive. Des exemples classiques de jonctions semiconductrices dont les propriétés sont modifiées par déplétion, injection ou accumulation de porteurs sont donnés notamment dans la publication de Reed et al. intitulée Silicon optical modulators, Nature photonics 4, 518-526 (2010). Comme mentionné précédemment en référence à l'art antérieur, les déphaseurs électro-réfractifs 23a, 23b présente un temps de commutation Δt_{ER} particulièrement court, habituellement de l'ordre de quelques nanosecondes, mais entraîne des pertes d'insertions et des variations de pertes d'insertion en fonction de la tension/courant de commande qui peuvent provoquer une dégradation du taux d'extinction (mauvaise isolation entre les deux ports de sortie).

Le module de compensation 24 est adapté à appliquer un signal de compensation V_{ERa}, V_{ERb} aux déphaseurs électro-réfractifs 23a, 23b. Ce signal de compensation est transitoire, c'est-à-dire momentané, et présente une intensité variable. Il permet de générer une composante supplémentaire, dite électro-réfractive Δφ_{ER}(t), de la différence de phase effective Δφ_{eff}(t). Aussi, la différence de phase effective Aφ_{eff}(t) correspond à la somme de la composante thermo-optique Δφ_{TO}(t) et de la composante électro-réfractive Δφ_{ER}(t). Comme décrit en détail plus loin, l'intensité du signal de compensation V_{ERa}, V_{ERb} est déterminée de sorte que la composante électro-réfractive ΔΦ_{ER}(t) générée permette de minimiser, en temps réel, un écart Δφ_{f}-Δφ_{eff}(t) entre la valeur finale prédéterminée Δφ_{f} et la différence de phase effective Δφ_{eff}(t).

Le dispositif de commutation 20 comporte en outre deux photodétecteurs 25a, 25b, couplés optiquement aux ports 13a, 13b du coupleur de sortie 13, et connectés au module de compensation 24. Les photodétecteurs 25a, 25b reçoivent donc des signaux optiques correspondant à une partie du signal optique sortant sur l'un et l'autre des ports de sortie 13a, 13b, et transmettent au module de compensation 24 des signaux de mesure représentatifs de la puissance optique du signal optique sortant sur le port de sortie correspondant. Le module de compensation 24 comporte un calculateur 24.1 qui, sur la base des signaux de mesure, détermine la valeur de l'intensité du signal de compensation à appliquer aux déphaseurs électro-réfractifs 23a, 23b pour minimiser en temps réel l'écart entre la valeur finale Δφ_{f} et la différence de phase effective Δφ_{eff}.

Aussi, le module de compensation 24 est connecté aux déphaseurs électro-réfractifs 23a, 23b. A réception d'une instruction de commutation par le dispositif de commutation 20, le module de compensation 24 applique un signal de compensation V_{ERa}, V_{ERb} aux déphaseurs électro-réfractifs 23a, 23b. Ce signal de compensation est transitoire, c'est-à-dire momentané au cours de la durée T entre deux instructions de commutation consécutives, et d'intensité variable. L'intensité initiale appliquée à l'un ou l'autre des déphaseurs électro-réfractifs 23a, 23b est égale initialement à V_{ER,ref}+V_{ER,π}. La valeur V_{ER,ref} est une valeur de référence, constante dans le temps, pouvant être nulle. La valeur V_{ER,π} est une valeur initiale sensiblement égale à la valeur à appliquer pour que le déphaseur électro-réfractif 23a, 23b génère une variation de π de la phase φ du signal optique circulant dans le bras considéré 12a, 12b.

Comme détaillé plus loin, le signal de compensation V_{ERa}, V_{ERb} permet de générer la composante électro-réfractive ΔΦ_{ER}(t) de la différence de phase effective Δφ_{eff}(t), qui vient s'ajouter à la composante thermo-optique Δφ_{TO}(t). Dans la mesure où le signal de commutation V_{TOa}, V_{TOb} est continu et constant, la composante thermo-optique Δφ_{TO}(t) varie progressivement d'une valeur initiale Δφᵢ vers la valeur finale Δφ_{f} avec une constante de temps importante Δt_{TO}, de l'ordre de quelques microsecondes. En revanche, la différence de phase ΔΦ_{ER}(t) atteint la valeur finale Δφ_{f} avec une constante de temps très courte Δt_{ER}, de l'ordre de quelques nanosecondes. A mesure que la composante thermo-optique Δφ_{TO}(t) varie de la valeur initiale Δφᵢ vers la valeur finale Δφ_{f}, la composante électro-réfractive ΔΦ_{ER}(t) varie pour ainsi minimiser constamment l'écart entre la différence de phase effective Δφ_{eff}(t) et la valeur finale Δφ_{f}.

Ainsi, le commutateur 1 présente un temps de commutation très court, égal au temps de commutation Δt_{ER} de l'ordre de quelques nanosecondes. Il présente également des pertes d'insertion limitées ainsi qu'un taux d'extinction important dans la mesure où, lorsque la composante thermo-optique Δφ_{TO}(t) devient prépondérante dans la différence de phase effective Δφ_{eff}(t), la composante électro-réfractive ΔΦ_{ER}(t) devient faible puis négligeable, limitant ainsi le déséquilibre des pertes d'insertion induit par les déphaseurs 23a et 23b et donc la diaphotie associée.

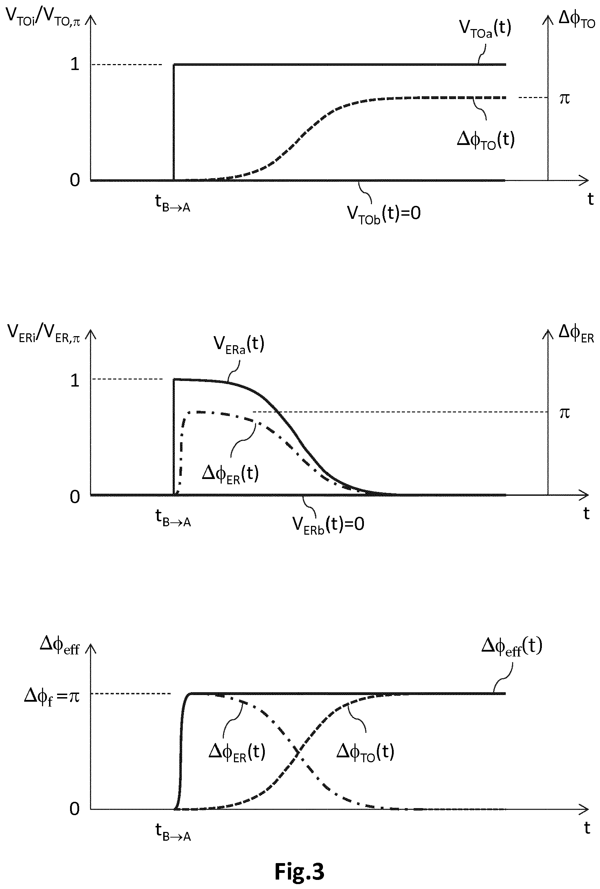

Le fonctionnement du commutateur 1 tel qu'illustré sur la fig.2 est maintenant décrit en détail, en référence aux figures 3 et 4.

On définit ici les termes utilisés pour la suite de la description :
▪ t_{B→A} et t_{A→B} représentent respectivement les instants de commutation du deuxième port au premier port du coupleur de sortie 13, et inversement ;
▪ Δφ_{eff}(t) est la différence de phase effective, instantanée à l'instant t, entre les signaux optiques circulant dans les bras de l'interféromètre 10. Elle est la somme de deux composantes, à savoir la composante thermo-optique Δφ_{TO}(t) issue des déphaseurs thermo-optiques 21a, 21b, et la composante électro-réfractive ΔΦ_{ER}(t) issue des déphaseurs électro-réfractifs 23a, 23b. La différence de phase effective Δφ_{eff}(t), ainsi que la composante thermo-optique Δφ_{TO}(t), varient entre ο et π. La composante électro-réfractive ΔΦ_{ER}(t) varie entre ο et Δφ_{f}-Δφ_{TO}(t). La variation d'une différence de phase entre ο et π s'entend modulo 2π.
▪ Δφ_{f} est la valeur finale prédéterminée de la différence de phase effective Δφ_{eff}(t) pour laquelle la commutation est réalisée. Elle est égale à ο ou π.
▪ V_{TO,π} et V_{ER,π} sont respectivement l'intensité du signal électrique appliqué à un déphaseur thermo-optique 21a, 21b par le module de commutation 22, et à un déphaseur électro-réfractif 23a, 23b par le module de compensation 24, pour induire une variation de π de la phase du signal optique le traversant.

On décrit tout d'abord la commutation du signal optique sortant du deuxième port au premier port du coupleur de sortie 13, en référence à la figure 3 qui illustre l'évolution temporelle :
▪ du signal de commutation V_{TOa}(t) et V_{TOb}(t) appliqué aux déphaseurs thermo-optiques 21a, 21b, et de la composante thermo-optique Δφ_{TO}(t) de la différence de phase effective Δφ_{eff}(t) qui en résulte ;
▪ du signal de compensation V_{ERa}(t) et V_{ERb}(t) appliqué aux déphaseurs électro-réfractifs 23a, 23b, et de la composante électro-réfractive ΔΦ_{ER}(t) de la différence de phase effective Δφ_{eff}(t) qui en résulte ; et
▪ de la différence de phase effective Δφ_{eff}(t) correspondant à la somme de la composante thermo-optique Δφ_{TO}(t) et de la composante électro-réfractive Δφ_{ER}(t).

A t<t_{B→A}, c'est-à-dire avant l'instruction de commuter le signal optique sortant du deuxième port 13b au premier port 13a du coupleur de sortie 13, le signal optique entrant est fourni au premier port 11a du coupleur d'entrée 11 et le signal optique sortant est émis par le deuxième port 13b du coupleur de sortie 13. Pour cela, le module de commutation 22 impose aux déphaseurs thermo-optiques 21a, 21b respectivement un signal de commutation d'intensité V_{TOa} et V_{TOb} telles que la composante thermo-optique Δφ_{TO}(t) de la différence de phase effective Δφ_{eff}(t) est nulle. Ici, les intensités V_{TOa} et V_{TOb} sont nulles, moyennant la valeur de référence V_{TO,ref} que l'on considère nulle dans la suite de la description. De plus, le module de compensation 24 impose aux déphaseurs électro-réfractifs 23a, 23b un signal transitoire de compensation d'intensité respectivement V_{ERa} et V_{ERb} telles que la composante ΔΦ_{ER}(t) à la différence de phase effective Δφ_{eff}(t) est nulle. Ici, les intensités V_{ERa} et V_{ERb} sont nulles, moyennant la valeur de référence V_{ER,ref} qui est nulle dans la suite de la description.

A t≥t_{B→A}, c'est-à-dire à partir de l'instant de commutation t_{B→A}, le module de commutation 22 applique aux déphaseurs thermo-optiques 21a, 21b un signal continu de commutation V_{TOa}, V_{TOb} et d'intensité constante, et le module de compensation 24 applique simultanément aux déphaseurs électro-réfractifs 23a, 23b un signal transitoire de compensation V_{ERa}, V_{ERb} et d'intensité variable.

Ainsi, le module de commutation 22 applique un signal continu de commutation V_{TOa}, V_{TOb} et d'intensité constante aux déphaseurs thermo-optiques 21a, 21b pour générer la composante thermo-optique Δφ_{TO}(t) entre les signaux optiques circulant dans les bras 12a, 12b, qui passe progressivement d'une valeur nulle à la valeur prédéterminée Δφ_{f} ici égale à π, se traduisant par une commutation du signal optique sortant du deuxième port 13b au premier port 13a du coupleur de sortie 13. Ici, le signal de commutation V_{TOa}(t) appliqué au premier déphaseur thermo-optique 21a présente une intensité constante V_{TOa}(t)=V_{TO,π} de sorte qu'il induit une variation de π de la phase φ_{A} du signal optique circulant dans le premier bras 12a. De plus, le signal de commutation V_{TOb}(t) appliqué au deuxième déphaseur thermo-optique 21b présente une intensité constante V_{TOb}(t)=o de sorte qu'il n'induit pas de variation de la phase φ_{B} du signal optique circulant dans le deuxième bras 12b. Ainsi, la différence de phase Δφ_{eff}(t) présente une composante thermo-optique Δφ_{TO}(t) qui varie progressivement de ο à Δφ_{f}=π, avec un temps caractéristique Δt_{TO} qui est le temps long de commutation des déphaseurs thermo-optiques, habituellement de l'ordre de quelques microsecondes.

Simultanément à l'application du signal de commutation V_{TOa}, V_{TOb} par le module de commutation 22, le module de compensation 24 applique un signal transitoire de compensation V_{ERa}, V_{ERb} d'intensité variable aux déphaseurs électro-réfractifs 23a, 23b pour générer la composante électro-réfractive ΔΦ_{ER}(t) permettant de minimiser l'écart entre Δφ_{f} et Δφ_{eff}(t). La composante électro-réfractive ΔΦ_{ER}(t) passe alors rapidement d'une valeur nulle à la valeur prédéterminée Δφ_{f} ici égale à π, en une constante de temps de l'ordre de la nanoseconde ou moins, puis diminue progressivement jusqu'à une valeur nulle, à mesure qu'augmente Δφ_{TO}(t).

Ici, le signal de compensation V_{ERa}(t) appliqué au premier déphaseur électro-réfractif 23a présente donc un pic d'intensité à la valeur V_{ER,π} de sorte qu'il induit immédiatement une variation de π de la phase φ_{A} du signal optique circulant dans le premier bras 12a, puis présente une décroissance d'intensité jusqu'à o. De plus, le signal de compensation V_{ERb}(t) appliqué au deuxième déphaseur électro-réfractif 23b présente une intensité constante V_{ER,B}(t)=ο de sorte qu'il n'induit pas de variation de la phase φ_{B} du signal optique circulant dans le deuxième bras 12b. Ainsi, la différence de phase Δφ_{eff}(t) présente, outre la composante thermo-optique Δφ_{TO}(t), une composante Δφ_{ER}(t) qui présente immédiatement un pic à Δφ_{f}=π puis diminue progressivement jusqu'à o. Le temps caractéristique de variation de ΔΦ_{ER}(t) de o à Δφ_{f} est le temps court de commutation Δt_{ER} des déphaseurs électro-réfractifs, qui peut être de l'ordre de quelques nanosecondes.

La variation d'intensité du signal de compensation V_{ERa}(t) est définie de sorte que l'écart entre la valeur déterminée Δφ_{f} et la différence de phase effective Δφ_{eff}(t) est minimisée, voire annulée. La valeur de l'intensité du signal V_{ERa}(t) est, dans cet exemple, déterminée à partir des signaux de mesure issus des photodétecteurs 25a, 25b. Ainsi, lors de l'application du signal de compensation d'intensité V_{ERa}(t)=V_{ER,π}, la différence de phase effective Δφ_{eff}(t) atteint une valeur de π de sorte que sensiblement toute la puissance optique est commutée du deuxième port 13b au premier port 13a. Les photodétecteurs 25a, 25b mesurent donc une puissance optique maximale sur le premier port 13a et une puissance optique minimale, sensiblement nulle, sur le deuxième port 13b. A mesure que la composante thermo-optique Δφ_{TO}(t) augmente, les photodétecteurs 25a, 25b mesurent une diminution de la puissance optique sur le premier port passant 13a, et une augmentation de la puissance optique sur le deuxième port non-passant 13b. A partir des signaux de mesure transmis par les photodétecteurs 25a, 25b, le calculateur 24.1 du module de compensation 24 détermine l'intensité variable à appliquer au premier déphaseur électro-réfractif 23a, qui se traduit par une diminution de la composante ΔΦ_{ER}(t) permettant de minimiser l'écart Δφ_{f}-Δφ_{eff}(t), entraînant une augmentation de la puissance optique sur le premier port passant 13a, et une diminution de la puissance optique sur le deuxième port non-passant 13b. Le taux d'extinction est ainsi amélioré (diaphotie réduite) puisque les déphaseurs électro-réfractifs 23a, 23b sont ramenés (ici le déphaseur 23a) à zéro, ce qui conduit à un équilibre optimal entre les pertes des bras.

Aussi, la commutation du deuxième port 13b au premier port 13a du coupleur de sortie 13 est effectuée par les déphaseurs thermo-optiques 21a, 21b dans la mesure où la différence de phase effective Δφ_{eff}(t) ne comporte à terme, c'est-à-dire après la phase transitoire de commutation, sensiblement que la composante thermo-optique Δφ_{TO}(t) laquelle est sensiblement égale à Δφ_{f}. Après la phase transitoire de commutation, les déphaseurs thermo-optiques 21a, 21b restent activés et les déphaseurs électro-réfractifs 23a, 23b sont désactivés, de sorte que le commutateur 1 présente des pertes d'insertion particulièrement faibles, et un taux d'extinction élevé (faible diaphotie). Par ailleurs, lors de la phase transitoire de commutation, le temps de commutation est très court du fait de l'activation (momentanée) des déphaseurs électro-réfractifs 23a, 23b. Ainsi, le commutateur 1 présente un temps de commutation très court, correspondant au temps de commutation électro-réfractif Δt_{ER} habituellement de l'ordre de quelques nanosecondes. On peut donc noter que la commutation est assurée par les déphaseurs thermo-optiques 21a, 21b, mais que le 'retard de commutation' est compensé par l'activation momentanée des déphaseurs électro-réfraCtifS 23a, 23b. Enfin, on note que le taux d'extinction est momentanément dégradé lors de l'activation transitoire des déphaseurs électro-réfractifs 23a, 23b. Cependant, cette dégradation momentanée est située aux premiers instants de la phase transitoire de commutation, ce qui n'affecte pas ou peu les informations-clés contenues dans le signal optique transmis, dans la mesure où ces informations-clés sont généralement précédées par des informations de moindre importance, par exemple des informations de synchronisation.

On décrit maintenant la commutation du signal optique sortant du premier port 13a au deuxième port 13b du coupleur de sortie 13, en référence à la figure 4 qui illustre l'évolution temporelle :
▪ du signal de commutation V_{TOa}(t) et V_{TOb}(t) appliqué aux déphaseurs thermo-optiques 21a, 21b, et de la composante thermo-optique Δφ_{TO}(t) qui en résulte ;
▪ du signal de compensation V_{ERa}(t) et V_{ERb}(t) appliqué aux déphaseurs électro-réfractifs 23a, 23b, et de la composante électro-réfractive ΔΦ_{ER}(t) qui en résulte ; et
▪ de la différence de phase effective Δφ_{eff}(t) correspondant à la somme de la composante thermo-optique ΔΦ_{TO} et de la composante électro-réfractive Δφ_{ER}.

A t<t_{A→B}, c'est-à-dire avant l'instruction de commuter le signal optique sortant du premier port 13a au deuxième port 13b du coupleur de sortie 13, le signal optique entrant est fourni au premier port 11a du coupleur d'entrée 11 et le signal optique sortant est émis par le premier port 13a du coupleur de sortie 13. Pour cela, le module de commutation 22 impose aux déphaseurs thermo-optiques 21a, 21b un signal de commutation d'intensité V_{TOa} et V_{TOb} telles que la composante thermo-optique Δφ_{TO}(t) est égale à Δφ_{f}=π. Ici, l'intensité V_{TOa}(t) est égale à V_{TO,π}, et l'intensité V_{TOb} est nulle (moyennant la valeur de référence V_{TO,ref} que l'on considère nulle, comme mentionné précédemment). De plus, le module de compensation 24 impose aux déphaseurs électro-réfractifs 23a, 23b un signal de compensation d'intensité V_{ERa} et V_{ERb} tel que la composante électro-réfractive ΔΦ_{ER}(t) est nulle. Ici, les intensités V_{ERa} et V_{ERb} sont nulles (moyennant la valeur de référence V_{ER,ref} qui est nulle, comme mentionné précédemment).

A t≥t_{A→B}, c'est-à-dire à partir de l'instant de commutation t_{A→B}, le module de commutation 22 applique aux déphaseurs thermo-optiques 21a, 21b un signal continu de commutation V_{TOa}, V_{TOb} et d'intensité constante, et le module de compensation 24 applique simultanément aux déphaseurs électro-réfractifs 23a, 23b un signal transitoire de compensation V_{ERa}, V_{ERb} et d'intensité variable.

Ainsi, le module de commutation 22 applique un signal continu de commutation V_{TOa}, V_{TOb} et d'intensité constante aux déphaseurs thermo-optiques 21a, 21b pour générer la composante thermo-optique Δφ_{TO}(t) entre les signaux optiques circulant dans les bras 12a, 12b, qui passe progressivement d'une valeur initiale Δφᵢ; égale à π jusqu'à la valeur finale Δφ_{f} égale à ο, se traduisant par une commutation du signal optique sortant du premier port 13a au deuxième port 13b du coupleur de sortie 13. Ici, le signal de commutation V_{TOa}(t) appliqué au premier déphaseur thermo-optique 21a maintient son intensité constante V_{TOa}(t)=V_{TO,π}, et le signal de commutation V_{TOb}(t) appliqué au deuxième déphaseur thermo-optique 21b passe d'une intensité nulle à une intensité constante V_{TOb}(t)=V_{TO,π} pendant une durée supérieure à la constante de temps thermo-optique Δt_{TO}. Ainsi, la différence de phase Δφ_{eff}(t) présente une composante thermo-optique Δφ_{TO}(t) qui varie progressivement de Δφᵢ=π à Δφ_{f}=o, avec une constante de temps thermo-optique Δt_{TO} qui est le temps long de commutation des déphaseurs thermo-optiques, habituellement de l'ordre de quelques microsecondes.

Simultanément à l'application du signal de commutation V_{TOa}, V_{TOb} par le module de commutation 22, le module de compensation 24 applique un signal transitoire de compensation V_{ERa}, V_{ERb} d'intensité variable aux déphaseurs électro-réfractifs 23a, 23b pour générer la composante électro-réfractive ΔΦ_{ER}(t) permettant de minimiser l'écart entre Δφ_{f} et Δφ_{eff}(t). La composante électro-réfractive ΔΦ_{ER}(t) passe alors rapidement d'une valeur nulle à la valeur -π, en une constante de temps de l'ordre de la nanoseconde ou moins, puis revient progressivement jusqu'à la valeur nulle à mesure que diminue Δφ_{TO}(t).

Ici, le signal de compensation V_{ERb}(t) appliqué au deuxième déphaseur électro-réfractif 23b présente donc un pic d'intensité à la valeur V_{ER,π} de sorte qu'il induit immédiatement une variation de π de la phase φ_{B} du signal optique circulant dans le deuxième bras 12b, puis présente une décroissance d'intensité jusqu'à o. De plus, le signal de compensation V_{ERa}(t) appliqué au premier déphaseur électro-réfractif 23a présente une intensité constante V_{ERa}(t)=o de sorte qu'il n'induit pas de variation de la phase φ_{A} du signal optique circulant dans le premier bras 12a. Ainsi, la différence de phase Δφ_{eff}(t) présente, outre la composante thermo-optique Δφ_{TO}(t), une composante ΔΦ_{ER}(t) qui présente immédiatement un pic à -π puis varie progressivement jusqu'à o. Le temps caractéristique de variation de ΔΦ_{ER}(t) de o à -π est le temps court de commutation Δt_{ER} des déphaseurs électro-réfractifs, qui peut être de l'ordre de quelques nanosecondes.

La variation d'intensité du signal de compensation V_{ERb}(t) est définie de sorte que l'écart entre la valeur déterminée Δφ_{f} et la différence de phase effective Δφ_{eff}(t) est minimisée, voire annulée. La valeur de l'intensité du signal V_{ERb}(t) est, dans cet exemple, déterminée à partir des signaux de mesure issus des photodétecteurs 25a, 25b. Ainsi, lors de l'application de la V_{ERb}(t)=V_{ER,π} par le signal de compensation, la différence de phase effective Δφ_{eff}(t) atteint une valeur nulle de sorte que sensiblement toute la puissance optique est commutée du premier port 13a au deuxième port de sortie 13b. Les photodétecteurs 25a, 25b mesurent donc une puissance optique maximale sur le deuxième port 13b et une puissance optique minimale, sensiblement nulle, sur le premier port 13a. A mesure que la composante thermo-optique Δφ_{TO}(t) diminue, les photodétecteurs 25a, 25b mesurent une diminution de la puissance optique sur le deuxième port passant 13b, et une augmentation de la puissance optique sur le premier port non-passant 13a. A partir des signaux de mesure transmis par les photodétecteurs 25a, 25b, le calculateur 24.1 du module de compensation 24 détermine l'intensité variable à appliquer au premier déphaseur électro-réfractif 23a, qui se traduit par une diminution de la composante ΔΦ_{ER}(t) permettant de minimiser l'écart Δφ_{f}-Δφ_{eff}(t), entraînant une augmentation de la puissance optique sur le deuxième port passant 13b, et une diminution de la puissance optique sur le premier port non-passant 13a. Le taux d'extinction est ainsi amélioré (diaphotie réduite), puisque les déphaseurs électro-réfractifs 23a, 23b sont ramenés à zéro, ce qui conduit à un équilibre optimal entre les pertes des bras.

Aussi, la commutation du premier port 13a au deuxième port 13b du coupleur de sortie 13 est effectuée par les déphaseurs thermo-optiques 21a, 21b avec le temps long Δt_{TO} de commutation thermo-optique. Le 'retard de commutation' est compensé par l'activation (momentanée) des déphaseurs électro-réfractifs 23a, 23b, de sorte que le commutateur 1 présente un temps de commutation très court, correspondant au temps Δt_{ER} de commutation électro-réfractif, habituellement de l'ordre de quelques nanosecondes. Par ailleurs, dans la mesure où la différence de phase effective Aφ_{eff}(t) ne comporte à terme, c'est-à-dire après la phase transitoire de commutation, sensiblement que la contribution thermo-optique Aφ_{TO} laquelle est égale à Δφ_{f} (les déphaseurs électro-réfractifs 23a, 23b étant désactivés), le commutateur 1 présente des pertes d'insertion particulièrement faibles, et un taux d'extinction élevé (faible diaphotie).

Enfin, à partir de l'instant t' supérieur au temps Δt_{TO} de commutation thermo-optique, les signaux de commutation V_{TOa}(t) et V_{TOb}(t) présentent une intensité qui varie de manière identique de V_{TO,π} à zéro, de manière à garder une contribution Δφ_{TO}(t) sensiblement nulle. La différence de phase effective Δφ_{eff}(t) n'est ainsi pas modifiée. La commutation ultérieure du deuxième port 13b au premier port 13a pourra ainsi être effectuée.

La figure 5 une vue schématique et partielle d'un commutateur optoélectronique 1 de type Mach-Zehnder (MZ) selon une variante du mode de réalisation illustré sur la fig.2. Le commutateur 1 s'en distingue essentiellement en ce que l'intensité variable du signal de compensation V_{ERa}, V_{ERb} appliqué aux déphaseurs électro-réfractifs 23a, 23b n'est pas déterminée à partir des signaux de mesure transmis par des photodétecteurs 25a, 25b, mais est fourni par une mémoire 24.2 contenant une loi d'évolution temporelle de l'intensité variable. Cette loi d'évolution temporelle a été préalablement déterminée à partir, par exemple, d'essais expérimentaux ou de simulations numériques du comportement électronique et optique du commutateur 1.

Des modes de réalisation particuliers viennent d'être décrits.

Ainsi, le commutateur 1 peut comporter un ou plusieurs déphaseurs thermo-optiques supplémentaires, couplés optiquement aux photodétecteurs, permettant notamment de corriger d'éventuelles erreurs de phase entre les signaux optiques circulant dans les bras de l'interféromètre 10, par exemple issues d'une dérive thermique de l'un ou l'autre des bras.

## Revendications

1. Commutateur optoélectronique (1), comportant :
∘ un interféromètre (10) de Mach-Zehnder, comportant :
• un coupleur d'entrée (11), comportant au moins un premier port d'entrée (11a) adapté à recevoir un signal optique dit entrant ;
• un premier et un deuxième guides d'onde dits bras (12a, 12b), reliés au coupleur d'entrée (11), adaptés à transmettre des signaux optiques, issus du signal optique entrant, et pouvant présenter une différence de phase dite effective (Δφ_{eff}(t)) ;
• un coupleur de sortie (13), relié aux bras (12a, 12b), et comportant deux ports de sortie (13a, 13b), pour fournir un signal optique dit sortant,
∘ un dispositif de commutation (20), comportant :
• au moins deux déphaseurs thermo-optiques (21a, 21b) disposés au niveau des bras (12a, 12b),
• un module de commutation (22) adapté à appliquer aux déphaseurs thermo-optiques (21a, 21b) un signal continu, dit de commutation, d'intensité constante durant toute la durée (T) séparant deux instructions de commutation consécutives,
▪ de manière à générer une composante (Δφ_{TO}(t)), dite thermo-optique, de la différence de phase effective (Δφ_{eff}(t)), qui varie jusqu'à une valeur finale prédéterminée (Δφ_{f}) se traduisant par une commutation du signal optique sortant sur l'un ou l'autre des ports de sortie (13a, 13b) ;
• au moins deux déphaseurs électro-réfractifs (23a, 23b) disposés au niveau des bras (12a, 12b),
• un module de compensation (24) adapté à appliquer aux déphaseurs électro-réfractifs (23a, 23b) un signal transitoire, dit de compensation, d'intensité variable durant toute la durée (T) séparant deux instructions de commutation consécutives, de manière à générer une composante (Δφ_{ER}(t)) supplémentaire, dite électro-réfractive, de la différence de phase effective (Δφ_{eff}(t)), la différence de phase effective (Δφ_{eff}(t)) étant ainsi égale à la somme de la composante thermo-optique (Δφ_{TO}(T)) et de la composante électro-réfractive (Δφ_{ER}(t)), ladite intensité variable étant déterminée de manière à minimiser un écart (Δφ_{f}-Δφ_{eff}(t)) entre la valeur finale prédéterminée (Δφ_{f}) et la différence de phase effective (Δφ_{eff}(t)) ;
**caractérisé en ce que** le dispositif de commutation (20) comporte en outre :
▪ au moins un photodétecteur (25a, 25b) couplé à l'un des ports de sortie (13a, 13b) et connecté au module de compensation (24), le module de compensation (24) comportant un calculateur (24.1) pour déterminer, sur la base de signaux de mesure transmis par le photodétecteur (25a, 25b), l'intensité variable à appliquer de manière à minimiser ledit écart entre la valeur finale prédéterminée (Δφ_{f}) et la différence de phase effective (Δφ_{eff}(t)).

2. Commutateur optoélectronique (1) selon la revendication 1, dans lequel les déphaseurs électro-réfractifs (23a, 23b) sont des diodes pin, des diodes pn, ou des structures capacitives à accumulation de porteurs.

3. Commutateur optoélectronique (1) selon l'une quelconque des revendications 1 à 2, dans lequel les bras (12a, 12b) sont réalisés à base de silicium.

4. Commutateur optoélectronique (1) selon l'une quelconque des revendications 1 à 3, dans lequel l'interféromètre (10) de Mach-Zehnder est un interféromètre 2×2 dont le coupleur d'entrée (11) comporte deux ports d'entrée (11a, 11b).

5. Procédé de commutation d'un signal optique de sortie de l'un à l'autre des ports de sortie (13a, 13b) d'un commutateur optoélectronique (1) selon l'une quelconque des revendications précédentes comportant les étapes suivantes :
i) application du signal de commutation (V_{TOa}, V_{TOb}) aux déphaseurs thermo-optiques (21a, 21b) de manière à générer la composante thermo-optique (Δφ_{TO}(t)) de la différence de phase effective (Δφ_{eff}(t)), qui varie jusqu'à la valeur finale prédéterminée (Δφ_{f}) se traduisant par la commutation du signal optique sortant ;
ii) application du signal transitoire de compensation (V_{ERa}, V_{ERb}) aux déphaseurs électro-optiques (23a, 23b) de manière à générer la composante électro-réfractive (Δφ_{ER}(t)) de la différence de phase effective (Aφ_{eff}(t)), dont l'intensité variable est déterminée de manière à minimiser ledit écart (Δφ_{f}-Δφ_{eff}(t)) entre la valeur finale prédéterminée (Δφ_{f}) et la différence de phase effective (Δφ_{eff}(t)).

6. Procédé de commutation selon la revendication 5, dans lequel le signal de commutation (V_{TOa}, V_{TOb}) est adapté à entraîner une variation allant de ο à π, et inversement, de la contribution thermo-optique (Δφ_{TO}(t)) de la différence de phase effective (Δφ_{eff}(t)), sur une durée caractéristique de variation (Δt_{TO}) dite thermo-optique.

7. Procédé de commutation selon la revendication 6, dans lequel le signal de compensation (V_{ERa}, V_{ERb}) est adapté à entraîner :
- une variation allant de ο à ±π de la composante électro-réfractive (Δφ_{ER}(t)) de la différence de phase effective (Δφ_{eff}(t)), sur une durée caractéristique de variation (Δt_{ER}) dite électro-réfractif inférieure à la durée caractéristique de variation (Δt_{TO}) thermo-optique,
- suivie d'un retour à ο, sur une durée caractéristique de variation sensiblement égale à la durée caractéristique de variation (Δt_{TO}) thermo-optique.

8. Procédé de commutation selon l'une quelconque des revendications 5 à 7, dans lequel, en l'absence de différence de phase entre les signaux optiques circulant dans les bras (12a, 12b), le signal optique sortant est émis au deuxième port (13b) du coupleur de sortie (13), la commutation du deuxième port (13b) au premier port (13a) du coupleur de sortie (13) comportant les étapes suivantes :
- application du signal de commutation (V_{TOa}, V_{TOb}), de sorte que la composante thermo-optique (Δφ_{TO}(t)) de la différence de phase effective (Δφ_{eff}(t)) passe de o à π ;
- application du signal de compensation (V_{ERa}, V_{ERb}), de sorte que la composante électro-réfractive (Δφ_{ER}(t)) de la différence de phase effective (Δφ_{eff}(t)) passe de o à π, puis diminue jusqu'à o à mesure que la composante thermo-optique (Δφ_{TO}(t)) augmente progressivement de o à π.

9. Procédé de commutation selon la revendication 8, dans lequel :
- l'application du signal de commutation (V_{TOa}, V_{TOb}) revient à appliquer au déphaseur thermo-optique (21a) situé dans le premier bras (12a) un signal continu (V_{TOa}) d'intensité constante V_{TO,π} entraînant une variation de π de la phase (φ_{A}) du signal optique circulant dans le premier bras (12a), et à appliquer au déphaseur thermo-optique (21b) situé dans le deuxième bras (12b) un signal (V_{TOb}) d'intensité nulle ;
- l'application du signal de compensation (V_{ERa}, V_{ERb}) revient à appliquer au déphaseur électro-réfractif (23a) situé dans le premier bras (12a) un signal transitoire (V_{ERa}) d'intensité variable passant de o à une valeur V_{ER,π} entraînant une variation de π de la phase (φ_{A}) du signal optique circulant dans le premier bras (12a), suivie d'une diminution à une valeur nulle à mesure que la composante thermo-optique (Δφ_{TO}(t)) augmente progressivement de o à π, et à appliquer au déphaseur électro-réfractif (23b) situé dans le deuxième bras (12b) un signal (V_{ERb}) d'intensité nulle.

10. Procédé de commutation selon l'une quelconque des revendications 5 à 8, dans lequel, en l'absence de différence de phase entre les signaux optiques circulant dans les bras (12a, 12b), le signal optique sortant étant émis au deuxième port (13b) du coupleur de sortie (13), la commutation du premier port (13a) au deuxième port (13b) du coupleur de sortie (13) comporte :
- application du signal de commutation (V_{TOa}, V_{TOb}), de sorte que la composante thermo-optique (Δφ_{TO}(t)) passe de π à ο ;
- application du signal de compensation (V_{ERa}, V_{ERb}), de sorte que la composante électro-réfractive (Δφ_{ER}(t)) passe de o à -π, puis augmente jusqu'à o, à mesure que la composante thermo-optique (Δφ_{TO}(t)) diminue progressivement de π à ο.

11. Procédé de commutation selon la revendication 10, dans lequel :
- l'application du signal de commutation (V_{TOa}, V_{TOb}) revient à appliquer au déphaseur thermo-optique (21b) situé dans le premier bras (12b) un signal continu (V_{TOa}) d'intensité constante Y_{TO,π}, et à appliquer au déphaseur thermo-optique (21b) situé dans le deuxième bras (12b) un signal continu (V_{TOb}) d'intensité constante V_{TO,π} entraînant une variation de π de la phase (φ_{B}) du signal optique circulant dans le deuxième bras (12b);
- l'application du signal de compensation (V_{ERa}, V_{ERb}) revient à appliquer au déphaseur électro-réfractif (23a) situé dans le premier bras (12a) un signal (V_{ERa}) d'intensité nulle, et à appliquer au déphaseur électro-réfractif (23b) situé dans le deuxième bras (12b) un signal (V_{ERb}) d'intensité variable passant de o à une valeur V_{ER,π} entraînant une variation de π de la phase (φ_{B}) du signal optique circulant dans le deuxième bras (12b), suivie d'un retour à une valeur nulle à mesure que la composante thermo-optique (Δφ_{TO}(t)) diminue progressivement de π à o.

## Patentansprüche

1. Optoelektronischer Schalter (1), der Folgendes aufweist:
∘ ein Mach-Zehnder Interferometer (10), das Folgendes aufweist:
• einen Eingangskoppler (11), der mindestens einen ersten Eingangsport (11a) aufweist, der ausgeführt ist, um ein sogenanntes ankommendes optisches Signal zu empfangen;
• einen ersten und einen zweiten Wellenleiter, genannt Arme (12a, 12b), die mit dem Eingangskoppler (11) verbunden sind und ausgeführt sind, um optische Signale zu übertragen, die aus dem ankommenden optischen Signal stammen und eine sogenannte effektive Phasendifferenz (Δφ_{eff}(t)) aufweisen können;
• einen Ausgangskoppler (13), der mit den Armen (12a, 12b) verbunden ist und zwei Ausgangsports (13a, 13b) aufweist, um ein sogenanntes ausgehendes optisches Signal zu liefern,
o eine Schaltvorrichtung (20), die Folgendes aufweist:
• mindestens zwei auf Höhe der Arme (12a, 12b) angeordnete thermo-optische Phasenschieber (21a, 21b),
• ein Schaltmodul (22), das ausgeführt ist, um an die thermo-optischen Phasenschieber (21a, 21b) ein kontinuierliches Signal, das sogenannte Schaltsignal, mit konstanter Intensität während der gesamten Zeit (T) anzulegen, die zwei aufeinander folgende Schaltbefehle trennt,
▪ in der Art, dass eine sogenannte thermo-optische Komponente (Δφ_{TO}(t)) der effektiven Phasendifferenz (Δφ_{eff}(t)) erzeugt wird, die sich bis zu einem vorgegebenen Endwert (Δφ_{f}) ändert, was zu einem Schalten des ausgehenden optischen Signals auf einen der beiden Ausgangsports (13a, 13b) führt;
• mindestens zwei auf Höhe der Arme (12a, 12b) angeordnete elektro-refraktive Phasenschieber (23a, 23b),
• ein Schaltmodul (24), das ausgeführt ist, um an die thermo-optischen Phasenschieber (23a, 21b) ein transientes Signal, das sogenannte Kompensationssignal, mit variabler Intensität während der gesamten Zeit (T) anzulegen, die zwei aufeinander folgende Schaltbefehle trennt,
▪ in der Art, dass eine zusätzliche sogenannte elektro-refraktive Komponente (Δφ_{ER}(t)) der effektiven Phasendifferenz (Δφ_{eff}(t)) erzeugt wird, wobei die effektive Phasendifferenz (Δφ_{eff}(t)) somit gleich der Summe aus der thermo-optischen Komponente (Δφ_{TO}(t)) und der elektro-refraktiven Komponente (Δφ_{ER}(t)) ist, wobei die variable Intensität in der Art festgelegt wird, dass ein Abstand (Δφ_{f}-Δφ_{eff}(t)) zwischen dem vorgegebenen Endwert (Δφ_{f}) und der effektiven Phasendifferenz Δφ_{eff}(t) minimiert wird;
**dadurch gekennzeichnet, dass** die Schaltvorrichtung (20) darüber hinaus Folgendes aufweist:
▪ mindestens einen Photodetektor (25a, 25b), der mit einem der Ausgangsports (13a, 13b) gekoppelt und an das Kompensationsmodul (24) angeschlossen ist, wobei das Kompensationsmodul (24) einen Rechner (24.1) zum Bestimmen der variablen Intensität auf der Grundlage der durch den Photodetektor (25a, 25b) übertragenen Messsignale aufweist, die so anzulegen ist, dass der Abstand zwischen dem vorgegebenen Endwert (Δφ_{f}) und der effektiven Phasendifferenz (Δφ_{eff}(t)) minimiert wird.

2. Optoelektronischer Schalter (1) nach Anspruch 1, wobei die elektro-refraktiven Phasenschieber (23a, 23b) Pin-Dioden sind, pn-Dioden, oder kapazitive Trägerakkumulationsstrukturen.

3. Optoelektronischer Schalter (1) nach einem der Ansprüche 1 bis 2, wobei die Arme (12a, 12b) aus Silizium bestehen.

4. Optoelektronischer Schalter (1) nach einem der Ansprüche 1 bis 3, wobei das Mach-Zehnder Interferometer (10) ein 2x2 Interferometer ist, dessen Eingangskoppler (11) zwei Eingangsports (11a, 11b) aufweist.

5. Verfahren zum Schalten eines optischen Ausgangssignals von einem auf den anderen Ausgangsport (13a, 13b) eines optoelektronischen Schalters (1) nach einem der vorhergehenden Ansprüche, das die folgenden Schritte aufweist:
i) Anlegen des Schaltsignals (V_{TOa}, V_{TOb}) an die thermo-optischen Phasenschieber (21a, 21b) in der Art, dass die thermo-optische Komponente (Δφ_{TO}(t)) der effektiven Phasendifferenz (Δφ_{eff}(t)) erzeugt wird, die sich bis zu dem vorgegebenen Endwert (Δφ_{f}) ändert, was zu einem Schalten des ausgehenden optischen Signals führt;
ii) Anlegen des transienten Kompensationssignals (V_{ERa}, V_{ERb}) an die elektrooptischen Phasenschieber (23a, 23b) in der Art, dass die elektro-refraktive Komponente (Δφ_{ER}(t)) der effektiven Phasendifferenz (Δφ_{eff}(t)) erzeugt wird, wobei die variable Intensität in der Art festgelegt wird, dass der Abstand (Δφ_{f}-Δφ_{eff}(t)) zwischen dem vorgegebenen Endwert (Δφ_{f}) und der effektiven Phasendifferenz (Δφ_{eff}(t)) minimiert wird.

6. Schaltverfahren nach Anspruch 5, wobei das Schaltsignal (V_{TOa}, V_{TOb}) ausgeführt ist, um eine Änderung von 0 bis π und umgekehrt des thermo-optischen Beitrags (Δφ_{TO}(t)) der effektiven Phasendifferenz (Δφ_{eff}(t)) über eine sogenannte thermo-optische charakteristische Änderungsdauer (Δt_{TO}) herbeizuführen.

7. Schaltverfahren nach Anspruch 6, wobei das Kompensationssignal (V_{ERa}, V_{ERb}) ausgeführt ist, um Folgendes herbeizuführen:
- eine Änderung von 0 bis ±π der elektro-refraktiven Komponente (Δφ_{ER}(t)) der effektiven Phasendifferenz (Δφ_{eff}(t)) über eine sogenannte elektro-refraktive charakteristische Änderungsdauer (Δt_{ER})), die kleiner ist als die thermo-optische charakteristische Änderungsdauer (Δt_{TO}),
- gefolgt von einer Rückkehr zu 0 über eine charakteristische Änderungsdauer, die im Wesentlichen gleich der thermo-optische charakteristische Änderungsdauer (Δt_{TO}) ist.

8. Schaltverfahren nach einem der Ansprüche 5 bis 7, wobei beim Fehlen einer Phasendifferenz zwischen den in den Armen (12a, 12b) zirkulierenden optischen Signalen das ausgehende optische Signal am zweiten Port (13b) des Ausgangskopplers (13) ausgegeben wird und das Schalten des zweiten Ports (13b) auf den ersten Port (13a) des Ausgangskopplers (13) die folgenden Schritte aufweist:
- Anlegen des Schaltsignals (V_{TOa}, V_{TOb}) in der Art, dass die thermo-optische Komponente (Δφ_{TO}(t)) der Phasendifferenz (Δφ_{eff}(t)) von 0 auf π geht;
- Anlegen des Kompensationssignals (V_{ERa}, V_{ERb}) in der Art, dass die elektro-refraktive Komponente (Δφ_{ER}(t)) der Phasendifferenz(Δφ_{eff}(t)) von 0 auf π geht, dann auf 0 sinkt, je mehr die thermo-optische Komponente (Δφ_{TO}(t)) allmählich von 0 auf π ansteigt.

9. Schaltverfahren nach Anspruch 8, wobei:
- das Anlegen des Schaltsignals (V_{TOa}, V_{TOb}) darauf hinausläuft, dass an den thermo-optischen Phasenschieber (21a) im ersten Arm (12a) ein kontinuierliches Signal (V_{TOa}) mit konstanter Intensität V_{TO,π} angelegt wird, das eine Änderung von π der Phase (φ_{A}) des im ersten Arm (12a) zirkulierenden optischen Signals herbeiführt, und an den thermo-optischen Phasenschieber (21b) im zweiten Arm (12b) ein Signal (V_{TOb}) der Intensität Null angelegt wird;
- das Anlegen des Kompensationssignals (V_{ERa}, V_{ERb}) darauf hinausläuft, dass an den elektro-refraktiven Phasenschieber (23a) im ersten Arm (12a) ein transientes Signal (V_{ERa}) mit variabler Intensität von 0 auf einen Wert V_{ER,*π*} angelegt wird, das eine Änderung von π der Phase (φ_{A}) des im ersten Arm (12a) zirkulierenden optischen Signals herbeiführt, gefolgt von einer Senkung auf einen Wert Null, je mehr die thermo-optische Komponente (Δφ_{TO}(t)) allmählich von 0 auf π ansteigt, und an den elektro-refraktiven Phasenschieber (23b) im zweiten Arm (12b) ein Signal (V_{ERb}) der Intensität Null angelegt wird.

10. Schaltverfahren nach einem der Ansprüche 5 bis 8, wobei beim Fehlen einer Phasendifferenz zwischen den in den Armen (12a, 12b) zirkulierenden optischen Signalen das ausgehende optische Signal, das am zweiten Port (13b) des Ausgangskopplers (13) ausgegeben wird, und das Schalten ersten Ports (13a) auf den zweiten Port (13b) des Ausgangskopplers (13) Folgendes aufweist:
- Anlegen des Schaltsignals (V_{TOa}, V_{TOb}) in der Art, dass die thermo-optische Komponente (Δφ_{TO}(t)) von π auf 0 geht;
- Anlegen des Kompensationssignals (V_{ERa}, V_{ERb}) in der Art, dass die elektro-refraktive Komponente (Δφ_{ER}(t)) 0 auf -π geht, dann auf 0 ansteigt, je mehr die thermo-optische Komponente (Δφ_{TO}(t)) allmählich von π auf 0 sinkt.

11. Schaltverfahren nach Anspruch 10, wobei:
- das Anlegen des Schaltsignals (V_{TOa}, V_{TOb}) darauf hinausläuft, dass an den thermo-optischen Phasenschieber (21b) im ersten Arm (12b) ein kontinuierliches Signal (V_{TOa}) mit konstanter Intensität V_{TO,π} angelegt wird, und dass an den thermo-optischen Phasenschieber (21b) im zweiten Arm (12b) ein kontinuierliches Signal (V_{TOb}) mit konstanter Intensität V_{TO,π} angelegt wird, das eine Änderung von π der Phase (φ_{B}) des im zweiten Arm (12b) zirkulierenden optischen Signals herbeiführt;
- das Anlegen des Kompensationssignals (V_{ERa}, V_{ERb}) darauf hinausläuft, dass an den elektro-refraktiven Phasenschieber (23a) im ersten Arm (12a) ein Signal (V_{ERa}) der Intensität Null angelegt wird, und dass an den elektro-refraktiven Phasenschieber (23b) im zweiten Arm (12b) ein Signal (V_{ERb}) mit variabler Intensität von 0 auf einen Wert V_{ER,π} angelegt wird, das eine Änderung von π der Phase (φ)_{B}) des im zweiten Arm (12b) zirkulierenden optischen Signals herbeiführt, gefolgt von einer Rückkehr zu einem Wert Null, je mehr die thermo-optische Komponente (Δφ_{TO}(t)) allmählich von π auf 0 sinkt.

## Claims

1. Optoelectronic switch (1), comprising:
o a Mach-Zehnder interferometer (10), comprising:
• an input coupler (11), comprising at least a first input port (11a) designed to receive an optical signal referred to as incoming optical signal;
• first and second waveguides referred to as arms (12a, 12b), connected to the input coupler (11), designed to transmit optical signals, coming from the incoming optical signal, and able to have a phase difference referred to as effective phase difference (Δφ_{eff}(t));
• an output coupler (13), connected to the arms (12a, 12b), and comprising two output ports (13a, 13b), in order to supply an optical signal referred to as outgoing optical signal,
o a switching device (20), comprising:
• at least two thermo-optical phase-shifters (21a, 21b) disposed within the arms (12a, 12b),
• a switching module (22) designed to apply a continuous signal, referred to as switching signal, of intensity that remains constant throughout the duration (T) separating two consecutive switching instructions, to the thermo-optical phase-shifters (21a, 21b),
▪ in such a manner as to generate a component (Δφ_{TO}(t)), referred to as thermo-optical component, of the effective phase difference (ΔΦ_{eff}(t)), which varies up to a predetermined final value (Δφ_{f}) resulting in a switching of the outgoing optical signal onto one or the other of the output ports (13a, 13b);
• at least two electro-refractive phase-shifters (23a, 23b) disposed within the arms (12a, 12b),
• a compensation module (24) designed to apply to the electro-refractive phase-shifters (23a, 23b) a transient signal, referred to as compensation signal, of intensity that is variable throughout the duration (T) separating two consecutive switching instructions,
▪ in such a manner as to generate an additional component (Δφ_{ER}(t)), referred to as electro-refractive component, of the effective phase difference (Δφ_{eff}(t)), the effective phase difference (Δφ_{eff}(t)) thus being equal to the sum of the thermo-optical component (Δφ_{TO}(t)) and of the electro-refractive component (Δφ_{ER}(t)), the said variable intensity being determined in such a manner as to minimize the difference (Δφ_{f}-Δφ_{eff}(t)) between the predetermined final value (Δφ_{f}) and the effective phase difference (Δφ_{eff}(t));
**characterized in that** the switching device (20) further comprises:
▪ at least one photodetector (25a, 25b) coupled to one of the output ports (13a, 13b) and connected to the compensation module (24), the compensation module (24) comprising a processor (24.1) for determining, using measurement signals transmitted by the photodetector (25a, 25b), the variable intensity to be applied in such a manner as to minimize the said difference between the predetermined final value (Δφ_{f}) and the effective phase difference (Δφ_{eff}(t)).

2. Optoelectronic switch (1) according to Claim 1, in which the electro-refractive phase-shifters (23a, 23b) are pin diodes, pn diodes, or carrier accumulating capacitive structures.

3. Optoelectronic switch (1) according to either one of Claims 1 and 2, in which the arms (12a, 12b) are made of silicon.

4. Optoelectronic switch (1) according to any one of Claims 1 to 3, in which the Mach-Zehnder interferometer (10) is a 2x2 interferometer whose input coupler (11) comprises two input ports (11a, 11b).

5. Method of switching an output optical signal from one to the other of the output ports (13a, 13b) of an optoelectronic switch (1) according to any one of the preceding claims comprising the following steps:
i) application of the switching signal (V_{TOa}, V_{TOb}) to the thermo-optical phase-shifters (21a, 21b) in such a manner as to generate the thermo-optical component (Δφ_{TO}(t)) of the effective phase difference (ΔΦ_{eff}(t)), which varies up to the predetermined final value (Δφ_{f}) resulting in the switching of the outgoing optical signal;
ii) application of the transient compensation signal (V_{ERa}, V_{ERb}) to the electro-optical phase-shifters (23a, 23b) in such a manner as to generate the electro-refractive component (Δφ_{ER}(t)) of the effective phase difference (ΔΦ_{eff}(t)), whose variable intensity is determined in such a manner as to minimize the said difference (Δφ_{f}-Δφ_{eff}(t)) between the predetermined final value (Δφ_{f}) and the effective phase difference (Δφ_{eff}(t)).

6. Switching method according to Claim 5, in which the switching signal (V_{TOa}, V_{TOb}) is designed to drive a variation going from 0 to π, and vice versa, of the thermo-optical contribution (Δφ_{TO}(t)) of the effective phase difference (ΔΦ_{eff}(t)), over a characteristic duration of variation (Δt_{TO}), referred to as thermo-optical duration.

7. Switching method according to Claim 6, in which the compensation signal (V_{ERa}, V_{ERb}) is designed to drive:
- a variation going from 0 to ±π of the electro-refractive component (Δφ_{ER}(t)) of the effective phase difference (ΔΦ_{eff}(t)), over a characteristic duration of variation (Δt_{ER}), referred to as electro-refractive duration, less than the thermo-optical characteristic duration of variation (Δt_{TO}),
- followed by a return to 0, over a characteristic duration of variation substantially equal to the thermo-optical characteristic duration of variation (Δt_{TO}).

8. Switching method according to any one of Claims 5 to 7, in which, in the absence of a phase difference between the optical signals propagating in the arms (12a, 12b), the outgoing optical signal is sent to the second port (13b) of the output coupler (13), the switching from the second port (13b) to the first port (13a) of the output coupler (13) comprising the following steps:
- application of the switching signal (V_{TOa}, V_{TOb}), so that the thermo-optical component (Δφ_{TO}(t)) of the effective phase difference (Δφ_{eff}(t)) goes from 0 to π;
- application of the compensation signal (V_{ERa}, V_{ERb}), so that the electro-refractive component (Δφ_{ER}(t)) of the effective phase difference (Δφ_{eff}(t)) goes from 0 to π, then decreases down to 0 at the same time as the thermo-optical component (Δφ_{TO}(t)) progressively increases from 0 to π.

9. Switching method according to Claim 8, in which:
- the application of the switching signal (V_{TOa}, V_{TOb}) amounts to applying a continuous signal (V_{TOa}) of constant intensity V_{TO,π} to the thermo-optical phase-shifter (21a) situated in the first arm (12a) driving a variation of π of the phase (φ_{A}) of the optical signal propagating in the first arm (12a), and to applying a signal (V_{TOb}) of zero intensity to the thermo-optical phase-shifter (21b) situated in the second arm (12b);
- the application of the compensation signal (V_{ERa}, V_{ERb}) amounts to applying a transient signal (V_{ERa}) of variable intensity going from 0 to a value V_{ER,π}to the electro-refractive phase-shifter (23a) situated in the first arm (12a) driving a variation of π of the phase (φ_{A}) of the optical signal propagating in the first arm (12a), followed by a decrease to a zero value at the same time as the thermo-optical component (Δφ_{TO}(t)) progressively increases from 0 to π, and in applying a signal (V_{ERb}) of zero intensity to the electro-refractive phase-shifter (23b) situated in the second arm (12b).

10. Switching method according to any one of Claims 5 to 8, in which, in the absence of a phase difference between the optical signals propagating in the arms (12a, 12b), the outgoing optical signal being sent to the second port (13b) of the output coupler (13), the switching from the first port (13a) to the second port (13b) of the output coupler (13) comprises:
- application of the switching signal (V_{TOa}, V_{TOb}), so that the thermo-optical component (Δφ_{TO}(t)) goes from π to 0;
- application of the compensation signal (V_{ERa}, V_{ERb}), so that the electro-refractive component (Δφ_{ER}(t)) goes from 0 to -π, then increases up to 0, at the same time as the thermo-optical component (Δφ_{TO}(t)) progressively decreases from π to 0.

11. Switching method according to Claim 10, in which:
- the application of the switching signal (V_{TOa}, V_{TOb}) amounts to applying a continuous signal (V_{TOa}) of constant intensity V_{TO,π} to the thermo-optical phase-shifter (21b) situated in the first arm (12b), and in applying a continuous signal (V_{TOb}) of constant intensity V_{TO,π} to the thermo-optical phase-shifter (21b) situated in the second arm (12b) driving a variation of π of the phase (φ_{B}) of the optical signal propagating in the second arm (12b);
- the application of the compensation signal (V_{ERa}, V_{ERb}) amounts to applying a signal (V_{ERa}) of zero intensity to the electro-refractive phase-shifter (23a) situated in the first arm (12a), and in applying a signal (V_{ERb}) of variable intensity going from 0 to a value V_{ER,π}to the electro-refractive phase-shifter (23b) situated in the second arm (12b) driving a variation of π of the phase (φ_{B}) of the optical signal propagating in the second arm (12b), followed by a return to a zero value at the same time as the thermo-optical component (Δφ_{TO}(t)) progressively decreases from *π* to 0.
